## Europäisches Patentamt

## European Patent Office

## Office européen des brevets

(11) Publication number: **0 089 242**
**B1**

# EUROPEAN PATENT SPECIFICATION

(45) Date of publication of patent specification: **26.07.89**

(51) Int. Cl.⁴: **C 30 B 33/00, C 23 C 14/34**

(21) Application number: **83301464.0**

(22) Date of filing: **16.03.83**

(54) Method and apparatus for gas phase treatment of substrates.

(30) Priority: **16.03.82 JP 42456/82**

(43) Date of publication of application:
**21.09.83 Bulletin 83/38**

(45) Publication of the grant of the patent:
**26.07.89 Bulletin 89/30**

(84) Designated Contracting States:
**DE FR GB**

(56) References cited:
**EP-A-0 016 603**
**DE-A-3 022 259**
**US-A-4 268 538**
**US-A-4 298 629**

**PATENT ABSTRACTS OF JAPAN, vol. 6, no. 35**
**(C-93)(913), March 3, 1982**

(73) Proprietor: **FUJITSU LIMITED**
**1015, Kamikodanaka Nakahara-ku**
**Kawasaki-shi Kanagawa 211 (JP)**

(72) Inventor: **Ito, Takashi**
**408, Noborito Tama-ku**
**Kawasaki-shi Kanagawa 214 (JP)**
Inventor: **Kato, Ichiro**
**1745-20, Kisomachi**
**Machida-shi Tokyo 194 (JP)**

(74) Representative: **Lawrence, Peter Robin**
**Broughton et al**
**GILL JENNINGS & EVERY 53-64 Chancery Lane**
**London WC2A 1HN (GB)**

Courier Press, Leamington Spa, England.

## Description

The present invention relates to a method and apparatus for gas phase treatment of substrates, and in particular to a method and apparatus which can treat a large number of substrates in a single operation.

In one prior art gas phase treatment system, substrates to be treated, such as silicon wafers, are supported on a holder of, e.g. quartz and inserted in a reaction tube of quartz. The reaction tube is covered with a cover having a gas inlet port. A reaction gas is fed into the reaction tube through the inlet port and is evacuated through an outlet port so as to reduce the pressure in the tube to a required level. The substrates are heated to a reaction temperature by an electrical resistance heater or the like. The reaction gas flowing from the inlet to the outlet is excited to the plasma state by a work coil near the inlet and the plasma gas reaches the substrates and forms, for example, deposits on the substrates.

In this system the various substrates are located at different distances from where the reaction gas is excited. This makes it difficult to supply active reaction seeds uniformly to all substrates. Therefore, a large number of substrates cannot be treated in a single operation. Further, the lifetime of the excited state of the reaction gas is limited. If the lifetime is too short, active reaction seeds may not reach some or all of the substrates.

In an improved prior art system, substrates are held by susceptors made of carbon coated with a silicon carbide (SiC) film and arranged in parallel to each other in a reaction tube and the tube is surrounded by a work coil at the portion where the susceptors and substrates are placed. Details of this system are described in Nozaki et al., U.S. Patent No. 4,298,629. In this system, the work coil not only induction heats the susceptors, which heat the substrates by heat conduction, but also excites the reaction gas flowing near the susceptors and substrates. Therefore, the various substrates are all located close to where the reaction gas is excited, so the excited reaction gas can uniformly reach the substrates to the excited state.

A susceptor of, e.g., SiC coated carbon has a low electrical resistance and therefore easily carries induction currents, inhibiting excitation of the reaction gas nearby. This makes it necessary to space susceptors holding substrates at a certain distance, decreasing the number of substrates which can be treated in the system in a single operation. Further, disturbances of the electromagnetic field by the work coil and which are caused by the susceptors make it difficult to treat uniformly the entire surface of substrates held on the susceptors. Also the susceptors often tend to deteriorate by a reaction gas in a reaction tube.

In DE—A—3,022,259 plasma activated deposition processes are described for depositing a carbon film on a porous electrically conductive heating element. In DE—A—3,022,259 it is alleged that a reaction tube containing the element can be surrounded by a graphite susceptor which in turn can be surrounded by a high frequency copper coil.

It has been our object to avoid or minimise the above mentioned problems and to provide a process and apparatus that permits more uniform and effective gas phase treatment of a large number of substrates in a single operation.

In the invention a film is formed on a plurality of substrates by reaction of the substrates with a reaction gas in the plasma state by a method which comprises mounting the substrates on holders in a mounting zone in a reaction tube, heating the substrate by heating means that surround the mounting zone and passing the reaction gas through the tube while excited to the plasma state and the method is characterised in that the heating means are surrounded by a high frequency power supply and are heated by induction by the high frequency power supply and heat the substrates by radiation, there are spaces or spacers arranged intermittently lengthwise along the heating means and the high frequency power supply is transmitted through the spaces or spacers and excites the reaction gas in the mounting zone to the plasma state.

Apparatus according to the invention for gas phase treatment of a plurality of substrates comprises a reaction tube that has a gas inlet and a gas outlet for reaction gas and that includes a substrate mounting zone and holders for mounting the substrates in the mounting zone, heating means that surround the mounting zone and high frequency power supply means, and the apparatus is characterised in that the heating means are surrounded by the high frequency power supply means and are constructed such that in use they are heated by induction by the high frequency power supply means and heat the mounting zone by radiation, and there are spaces or spacers arranged intermittently lengthwise along the heating means such that in use the high frequency power is transmitted through the spaces or spacers for exciting reaction gas in the mounting zone to the plasma state.

It is particularly preferred that the substrates are heated substantially only by the said radiation from the heating means. In particular the substrates are preferably of silicon semi-conductor.

The heating means do not have to form a complete annulus provided they are distributed around the length of the mounting zone sufficient to generate adequately uniform heating of the substrates. Preferably substrates are mounted along the length of the tube in which event the mounting zone and the heating means and the power supply means will all extend substantially along the length of, and surround, the tube. The heating means are preferably substantially cylindrical.

The heating means must include, arranged intermittently length-wise, spaces or spacers permitting the passage through the heating means of the high frequency power, so as to excite the reaction gas in the reaction tube. Generally the heating means comprise a plurality of carbon based rings spaced apart from each other.

In the invention the reaction gas is excited at a place near each of substrates and the substrates can be arranged in parallel and very closely to each other since there are no susceptors or other conductive bodies very close to the substrates in the reaction tube. As a result, a large number of substrates can be treated uniformly in a single operation. The lifetime of the plasma state of a required reaction gas is therefore not a limiting factor for the number of substrates which can be treated.

The invention is now described in more detail with reference to the accompanying drawings in which:

Figure 1 is a sectional view of a prior art gas phase treatment system;

Figure 2 is a sectional view of an improved prior art gas phase treatment system;

Figure 3 is a sectional view of an apparatus for gas phase treating a substrate according to the present invention;

Figure 4 is a plan view of a wafer illustrating points where the thicknesses are measured;

Figure 5 is a partially cut-away perspective view of another apparatus for gas phase treating a substrate according to the present invention; and

Figure 6 is a sectional view of a still further apparatus for gas phase treating a substrate according to the present invention.

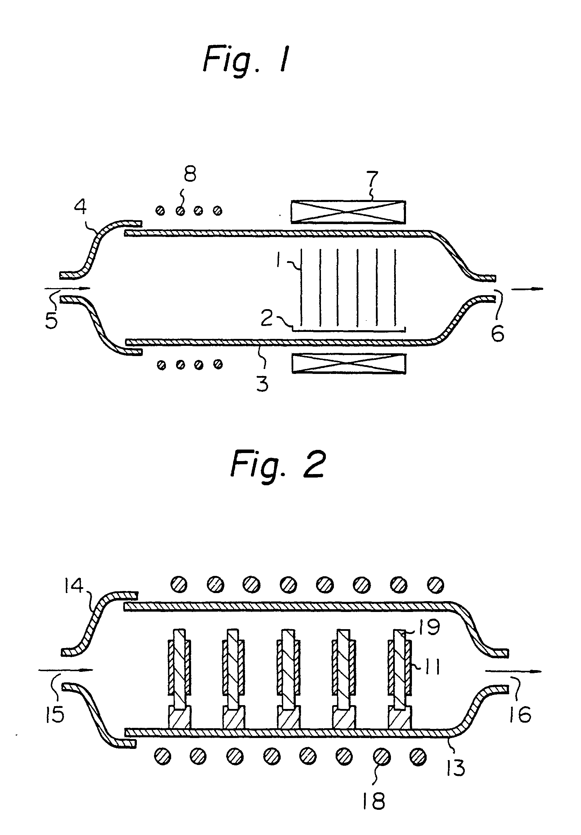

Figure 1 shows the prior art gas phase treatment system first mentioned above. Substrates 1, such as silicon wafers, are supported on a holder 2 of, e.g., quartz and inserted in a reaction tube 3 of quartz. The reaction tube 3 is covered with a cover 4 having a gas inlet port 5. A reaction gas is fed into the reaction tube 3 from an inlet port 5 and is evacuated through an outlet port 6 so as to reduce the pressure in the tube 3 to a required level. The substrates 1 are heated by a heater such as an electrical resistance heater 7. The reaction gas flowing from the inlet 5 to the outlet 6 is excited by a work coil 8 near the inlet 5 to the plasma states.

Figure 2 shows the improved prior art system, in which 11 denotes substrates, 13 a reaction tube, 14 a cover, 15 a gas inlet port, 16 a gas outlet port, 18 a work coil, and 19 SiC coated carbon susceptors.

The method and apparatus for gas phase treating a substrate in accordance with the present invention will now be explained.

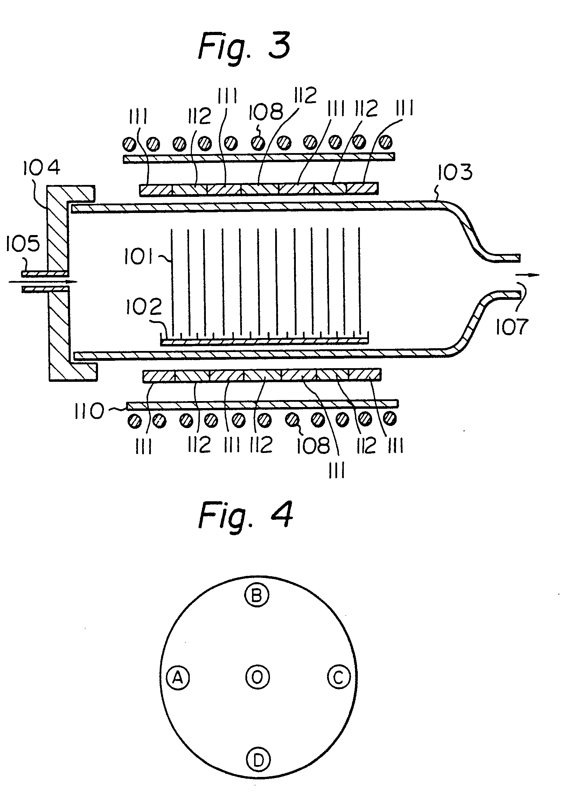

Figure 3 is a sectional view of an apparatus according to the present invention.

The apparatus, for example for direct nitridation of silicon (Si) wafers, can hold 20 silicon wafers (12 shown in Figure 3) 101 of 7.6 cm diameter and 500 μm (mirometer) thickness placed in a quartz holder 102 vertically and in parallel to each other at spaces of 5 mm. The holder 102 is placed in a reaction tube 103 of quartz and of 110 mm diameter, 1 m length, and 4 mm thickness. The reaction tube 103 has a quartz cover 104 on one end. A gas inlet port 105 is provided in the quartz cover 104, and a gas outlet port 107 is provided in the reaction tube 10 at the opposite end. A 40 cm-long conductor is wound on a support tube 110 around the reaction tube 103 30 times to form a work coil 108. Between the reaction tube 103 and the support tube 110, 10 radiators 111 (4 shown in Figure 3) of SiC film coated carbon are arranged. Each radiator 111 is in the form of a ring having a 120 mm inner diameter, a 130 mm outer diameter, and a 1 cm width. The 10 radiators 111 are spaced from each other by quartz spacers 112 of 1 cm width.

Purified ammonia ($NH_3$) gas is fed into the reaction tube 103 through the gas inlet port 105 in an amount of 300 $cm^3$/min and is evacuated through the gas outlet port 107 by a vacuum pump (not shown) to create a pressure of 100 to 130 Pa in the reaction tube 103. A high frequency power of 400 kHz, 6.5 kV, and 3 A is supplied to the work coil 108. This high frequency power heats the radiators 111 by induction. This heat is radiated to heat the silicon wafers 101 to a temperature of about 1000°C at their centres. The temperature of the silicon wafers 101 is as uniform as when heated by a conventional electrical resistance heater.

Part of the high frequency power supplied to the work coil 108 passes through the quartz spacers 112 to reach inside the reaction tube 103 and excite the ammonia gas, thereby decomposing the gas into nitrogen and hydrogen ions. The thus excited states have extremely short lifetimes, but the excited nitrogen ions reach the surfaces of the silicon wafers 101 due to the proximity between the place where the nitrogen ions are produced and the surfaces of the wafers. The nitrogen ions react with the silicon to form a silicon nitride (SiN) film at the surface of the silicon wafers 101.

In an actual experiment, the above treatment was continued for a period of 30 minutes to 1 hour to obtain a silicon nitride film having a thickness of 4 nm (40 Å). The thickness of the resultant silicon nitride film was determined at the centre and four peripheral points of the eight centre wafers of the 20 wafers inserted in the reaction tube 103.

The thickness at the centre points is shown in Table 1, in which the thicknesses are relative values.

TABLE 1
Film thickness distribution between wafers

| Wafer No. | Wafer centre thickness (Relative value) |
|-----------|------------------------------------------|
| 1 | 106 |
| 2 | 97 |
| 3 | 97 |
| 4 | 95 |
| 5 | 93 |
| 6 | 87 |
| 7 | 93 |
| 8 | 97 |

The four peripheral points were the points illustrated by marks A, B, C and D in Figure 4. The thicknesses at these points were evaluated as relative to the thickness at the centre point O and are shown in Table 2.

TABLE 2

| Wafer No. | Measured point | | | | |
|-----------|-----|-----|-----|-----|-----|
| | O | A | B | C | D |
| 1 | 100 | 112 | 94 | 99 | 105 |
| 2 | 100 | 103 | 103 | 101 | 101 |
| 3 | 100 | 103 | 109 | 100 | 98 |
| 4 | 100 | 98 | 106 | 98 | 101 |
| 5 | 100 | 100 | 104 | 98 | 98 |
| 6 | 100 | 105 | 107 | 96 | 99 |
| 7 | 100 | 102 | 101 | 97 | 104 |
| 8 | 100 | 115 | 97 | 96 | 97 |

As can be seen from Tables 1 and 2, the thicknesses of the resultant silicon nitride film are uniform between wafers and in each wafer within the tolerance for practical uses. In comparison, only one or no silicon nitride film having the film thickness within the tolerance can be obtained by the prior art method described before with reference to Figure 1 since the lifetime of the plasma gas excited from ammonia is extremely short. Further, in the method described before with reference to Figure 2, susceptors, each holding two silicon wafers, should be spaced at an approximately 4 cm distance. The resulting film thickness is therefore less uniform in a wafer and the number of wafers treatable in a single operation is smaller than the above.

It is obvious that more than eight wafers can be treated uniformly just by making the length of the apparatus longer.

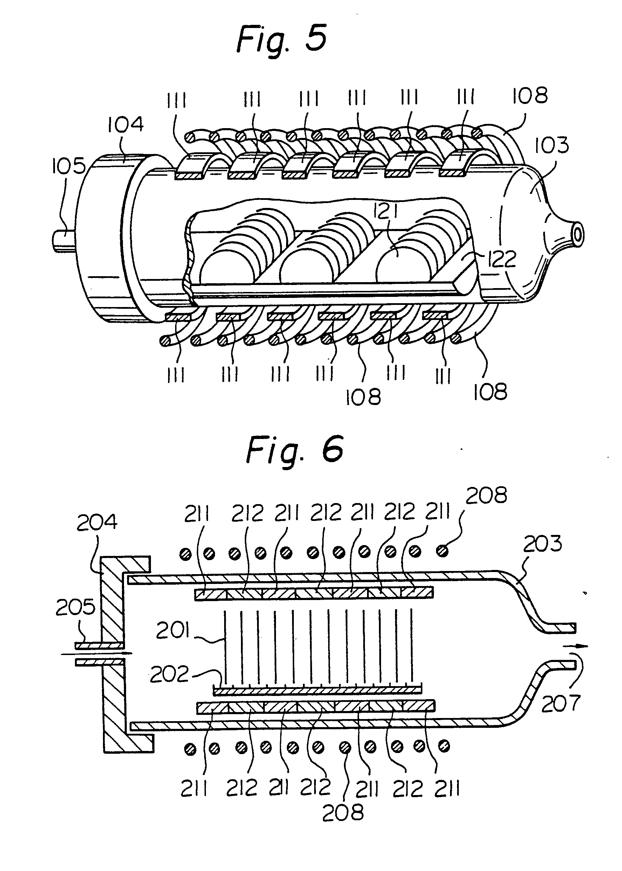

While in the above-mentioned embodiment of the present invention, silicon wafers are arranged such that the main surfaces of the wafers are perpendicular to the longitudinal axis of the reaction tube, the main surfaces of wafers may be arranged in parallel to that axis of the reaction tube as shown in Figure 5. Figure 5 illustrates such an arrangement of wafers in a raction tube. In this embodiment of the present invention, this apparatus and operation are the same as in the above-mentioned embodiment except that silicon wafers 121 held by a holder 122 are arranged vertically and in parallel to each other and to the axis of the reaction tube 103. Further, the main surfaces of wafers may be placed in other orientations in a reaction tube.

A silicon epitaxial layer can also be grown by basically the same method and apparatus as above but by feeding silicon tetrachloride gas diluted with hydrogen gas into the reaction tube instead of purified ammonia. The excited silicon tetrachloride gas easily decomposes and silicon atoms are bound with the silicon wafers to form an epitaxial layer onto the wafers. The epitaxial layers thus formed are uniform in thickness in each wafer and between wafers.

Basically the same method and apparatus as above can be also advantageously effected for other treatments, for example, plasma oxidation of the surface of a silicon wafer, provided the heating means, i.e. radiators 111 in Figure 3, are outside the reaction tube 103. If inside, they would be exposed to the plasma gas, resulting in deterioration. In a preferred plasma oxidation process, the space between the radiators is 2 cm; oxygen gas is fed into the reaction tube 103 and evacuated therefrom; high frequency power of 400 kHz, 6.5 kV, and 3.9 A is supplied; and the temperature of the silicon wafers is elevated to 900°C. The resultant silicon oxide film increases in thickness to 9 nm (90 Å) after a 60 minute treatment and to 13.3 nm (133 Å) after a 160 minute treatment.

However, radiators heated by a high frequency power supply means and for heating wafers may be provided either outside a reaction tube or inside a reaction tube. Figure 6 illustrates the latter system. In Figure 6, 201 denotes a wafer, 202 a holder, 203 a reaction tube, 204 a cover, 205 a gas inlet port, 207 a gas outlet port, and 208 a work coil. Radiators 211 of, e.g. SiC coated carbon and spacers 212 of, e.g. quartz are arranged between the wafers 201 received in the reaction tube 203 and the work coil 208 but inside the reaction tube 203, not outside. In this system the advantage of the present invention of uniform treatment of a large numebr of wafers in a single operation is also attained and the disadvantage of deterioration of the radiators is avoided by the use of a reaction gas that does not attack the material of which the radiators are formed.

It will be understood that the present invention is not limited to the above embodiments and that modifications are possible within the invention. For example, the means for supplying high frequency power may be of the capacitor type instead of the induction type. Further the invention may be advantageously applied for CVD of metal or oxide film, plasma etching treatment and other treatment of substrate in which plasma gas and an elevated temperature are used in addition to nitridation of silicon, epitaxial growth, and plasma oxidation.

## Claims

1. A method in which a film is formed on a plurality of substrates by reaction of the substrates with a reaction gas in the plasma state, the method comprising mounting the substrates on holders in a mounting zone in a reaction tube, heating the substrates by heating means that surround the mounting zone and passing the reaction gas through the tube while excited to the plasma state, characterized in that the heating means are surrounded by a high freauency power supply and are heated by induction by the high frequency power supply and heat the substrates by radiation, there are spaces or spacers arranged intermittently lengthwise along the heating means, and the high frequency power is transmitted through the spaces or spacers and excites the reaction gas in the mounting zone to the plasma state.

2. A method according to claim 1 in which the substrates are heated substantially only by the said radiation from the heating means.

3. A method according to claim 1 or claim 2 in which the substrates are of silicon semi-conductor.

4. A method according to any preceding claim in which the film that is formed by reaction of the substrates with the plasma is a film of silicon nitride, silicon oxide, or an epitaxial silicon layer.

5. A method according to any preceding claim in which the substrates are arranged vertically and spaced parallel to one another.

6. A method according to claim 5 in which the substrates are arranged perpendicularly to the longitudinal axis of the tube or are arranged parallel to the longitudinal axis of the tube.

7. A method according to any preceding claim in which the heating means are outside the reaction tube.

8. A method according to any preceding claim in which the high frequency power supply is a work coil that surrounds the heating means and the heating means comprise a plurality of carbon-based rings spaced apart from one another and positioned between the coil and the mounting zone.

9. Apparatus for the gas phase treatment of a plurality of substrates comprising a reaction tube that has a gas inlet and a gas outlet for reaction gas and that includes a substrate mounting zone including holders for mounting the substrates in the zone, and heating means that surround the mounting zone, and high frequency power supply means, characterised in that the heating means are surrounded by the high frequency power supply means and are constructed such that in use they are heated by induction by the high frequency power supply means and heat the mounting zone by radiation, and there are spaces or spacers arranged intermittently lengthwise along the heating means and that in use the high frequency power is transmitted through the spaces or spacers for exciting reaction gas in the mounting zone to the plasma state.

10. Apparatus according to claim 9 in which the high frequency power supply means is a work coil surrounding the heating means and the heating means is a plurality of carbon-based rings spaced apart from each other.

11. Apparatus according to claim 9 or 10 in which the heating means are outside the reaction tube.

## Patentansprüche

1. Verfahren, bei welchem ein Film auf einer Vielzahl von Substraten gebildet wird, durch Reaktion der Substrate mit einem Reaktionsgas im Plasmazustand, welches Verfahren die Montage der Substrate auf

# EP 0 089 242 B1

Haltern in einer Montagezone in einem Reaktionsrohr, das Heizen der Substrate durch Heizeinrichtungen, welche die Montagezone umgeben, und das Hindurchführen des Reaktionsgases durch das Rohr, während es in einen Plasmazustand angeregt ist, umfaßt, dadurch gekennzeichnet, daß die Heizeinrichtungen von einer Hochfrequenz-Energieversorgung umgeben und durch Induktion durch die Hochfrequenz-Energieversorgung geheizt werden und die Substrate durch Strahlung heizen, Abstande oder Abstandshalter intermittierend in Längsrichtung längs der Heizeinrichtung vorgesehen sind und die Hochfrequenzenergie durch die Abstände oder die Abstandshalter übertragen wird und das Reaktionsgas in der Montagezone in den Plasmazustand anregt.

2. Verfahren nach Anspruch 1, bei dem die Substrate im wesentlichen lediglich durch die genannte Strahlung von der Heizeinrichtung geheizt werden.

3. Verfahren nach Anspruch 1 oder 2, bei dem die Substrate aus Siliciumhalbleiter bestehen.

4. Verfahren nach einem der vorhergehenden Anspruche, bei dem der Film, der durch Reaktion der Substrate mit dem Plasma gebildet werden soll, ein Film aus Siliciumnitrid, Siliciumoxid oder eine epitaktische Siliciumschicht ist.

5. Verfahren nach einem der vorhergehenden Ansprüche, bei dem die Substrate vertikal und mit Abstand parallel zueinander angeordnet sind.

6. Verfahren nach Anspruch 5, bei dem die Substrate rechtwinklig zu der Längsachse des Rohrs oder parallel zu der Längsachse des Rohrs angeordnet sind.

7. Verfahren nach einem der vorhergehenden Ansprüche, bei dem die Heizeinrichtung außerhalb des Reaktionsrohrs ist.

8. Verfahren nach einem der vorhergehenden Ansprüche, bei dem die Hochfrequenz-Energieversorgung eine Belastungsspule ist, welche die Heizeinrichtung umgibt, und die Heizeinrichtung eine Vielzahl von auf Kohlenstoff basierenden Ringen umfaßt, die mit Abstand voneinander angeordnet und zwischen der Spule und der Montagezone positioniert sind.

9. Vorrichtung für die Gasphasenbehandlung einer Vielzahl von Substraten, mit einem Reaktionsrohr, das einen Gaseinlaß und einen Gasauslaß für das Reaktionsgas hat und eine Substratmontagezone enthält, die Halter zur Montage des Substrates in der Zone enthält, und Heizeinrichtungen, welche die Montagezone umgeben, und eine Hochfrequenz-Energieversorungseinrichtung, dadurch gekennzeichnet, das die Heizeinrichtung von der Hochfrequenz-Energieversorgungseinrichtung umgeben und so ausgebildet ist, daß sie in Betrieb durch Induktion durch die Hochfrequenz-Energieversorgungseinrichtung geheizt wird und die Heizzone durch Strahlung heizt, und daß Abstände oder Abstandshalter intermittierend in Längsrichtung längs der Heizeinrichtung so angeordnet sind, daß in Betrieb die Hochfrequenzenergie durch die Abstände oder Abstandshalter zur Anregung des Reaktionsgases in der Montagezone in den Plasmazustand übertragen wird.

10. Vorrichtung nach Anspruch 9, bei dem die Hochfrequenz-Energiezuführungseinrichtung eine Belastungsspule ist, welche die Heizeinrichtung umfaßt, die Heizeinrichtung eine Vielzahl von auf Kohlenstoff basierenden Ringen ist, die mit Abstand voneinander angeordnet sind.

11. Vorrichtung nach Anspruch 9 oder 10, bei der die Heizeinrichtung außerhalb des Reaktionsrohres ist.

**Revendications**

1. Un procédé selon lequel un film est formé sur une pluralité de substrats par réaction des substrats avec un gaz de réaction à l'état de plasma, ledit procédé comprenant le montage des substrats sur des supports dans une zone de montage dans un tube de réaction, le chauffage des substrats par des dispositifs chauffants qui entourent la zone de montage et le passage du gaz de réaction à travers le tube pendant qu'il est excité à l'état de plasma, caractérisé en ce que les dispositifs chauffants sont entourés par un dispositif d'alimentation de courant haute fréquence et sont chauffés par induction par le dispositif d'alimentation de courant haute fréquence et chauffent les substrats par rayonnement, des espaces ou des éléments d'écartement étant disposés de manière intermittente dans le sens de la longueur le long desdits dispositifs chauffants, et le courant haute fréquence étant transmis à travers les espaces ou les éléments d'écartement et excite le gaz de réaction dans la zone de montage pour l'amener à l'état de plasma.

2. Un procédé selon la revendication 1, selon lequel les substrats sont chauffés substantiellement seulement par ledit rayonnement provenant des dispositifs chauffants.

3. Un procédé selon la revendication 1 ou 2, selon lequel les substrats sont en silicium semi-conducteur.

4. Un procédé selon l'une quelconque des revendications précédentes, selon lequel le film qui est formé par réaction des substrats avec le plasma est un film de nitrure de silicium, d'oxyde de silicium ou une couche de silicium épitaxiale.

5. Un procédé selon l'une quelconque des revendications précédentes, selon lequel les substrats sont disposés verticalement et espacés parallèlement les uns par rapport aux autres.

6. Un procédé selon la revendication 5, selon lequel les substrats sont disposés perpendiculairement à l'axe longitudinal du tube ou sont disposés parallèlement à l'axe longitudinal du tube.

7. Un procédé selon l'une quelconque des revendications précédentes, selon lequel les dispositifs chauffants se trouvent à l'extérieur du tube de réaction.

8. Un procédé selon l'une quelconque des revendications précédentes, selon lequel le dispositif d'alimentation de courant haute fréquence est une bobine d'induction qui entoure les dispositifs chauffants et les dispositifs chauffants comprennent une pluralité de bagues à base de carbone espacées les unes par rapport aux autres et positionnées entre la bobine et la zone de montage.

9. Appareil pour le traitement en phase gazeuse d'une pluralité de substrats comprenant un tube de réaction qui comporte un orifice d'entrée de gaz et un orifice de sortie de gaz pour le gaz de réaction et qui inclut une zone de montage de substrats incluant des supports pour le montage des substrats dans la zone, et des dispositifs chauffants qui entourent la zone de montage, et un dispositif d'alimentation de courant haute fréquence, caractérisé en ce que les dispositifs chauffants sont entourés par le dispositif d'alimentation de courant haute fréquence et sont construits de façon qu'en fonctionnement ils sont chauffés par induction par le dispositif d'alimentation de courant haute fréquence et chauffent la zone de montage par rayonnement, et qu'il existe des espaces ou des éléments d'écartement disposés de manière intermittente dans le sens de la longueur le long des dispositifs chauffants de façon qu'en fonctionnement le courant haute fréquence est transmis à travers les espaces ou les éléments d'écartement pour exiter le gaz de réaction dans la zone de montage et l'amener à l'état de plasma.

10. Appareil selon la revendication 9, selon lequel le dispositif d'alimentation de courant haute fréquence est une bobine d'induction entourant les dispositifs chauffants et les dispositifs chauffants comprennent une pluralité de bagues à base de carbone espacées les unes des autres.

11. Appareil selon la revendication 9 ou 10, selon lequel les dispositifs chauffants se trouvent à l'extérieur du tube de réaction.

## Fig. 1

## Fig. 2

## Fig. 3

## Fig. 4

2

## Fig. 5

## Fig. 6